# FASCICULE DE BREVET EUROPEEN

(11) **EP 3 993 267 B1**
(45) Date de publication et mention de la délivrance du brevet: **03.07.2024**
(21) Numéro de dépôt: 21202147.1
(22) Date de dépôt: 12.10.2021
(51) Int. Cl.: H03K 19/00

(54) **CELLULE LOGIQUE CAPACITIVE À COMMANDE COMPLÉMENTAIRE**
KAPAZITIVE LOGISCHE ZELLE MIT KOMPLEMENTÄRSTEUERUNG
CAPACITIVE LOGIC CELL WITH SUPPLEMENTARY CONTROL

(30) Priorité: 27.10.2020 FR 2010976
(43) Date de publication de la demande: 04.05.2022
(73) Titulaire: Commissariat à l'Energie Atomique et aux Energies Alternatives, 75015 Paris (FR)
(72) Inventeur: PILLONNET, Gaël, 38054 GRENOBLE CEDEX 9 (FR); FANET, Hervé, 38054 GRENOBLE CEDEX 9 (FR)
(74) Mandataire: Cabinet Beaumont

(56) Documents cités:
- EP-A1- 3 182 590
- EP-A1- 3 435 546
- PILLONNET G ET AL: "Adiabatic capacitive logic: A paradigm for low-power logic", 2017 IEEE INTERNATIONAL SYMPOSIUM ON CIRCUITS AND SYSTEMS (ISCAS), IEEE, 28 mai 2017 (2017-05-28), pages 1-4, XP033156553, DOI: 10.1109/ISCAS.2017.8050996

## Description

### Domaine technique

La présente description concerne le domaine des circuits logiques adiabatiques réalisés à base de condensateurs à capacité variable, aussi appelés circuits logiques adiabatiques capacitifs.

### Technique antérieure

Le demandeur a déjà proposé, notamment dans la demande de brevet EP3182590, dans la demande de brevet EP3416175, dans la demande de brevet EP3435546, dans la demande de brevet FR1856243, et dans la demande de brevet EP3624123, des exemples de réalisation de cellules logiques adiabatiques capacitives élémentaires à base de condensateurs à capacité variable à commande électromécanique.

L'utilisation de condensateurs à capacité variable à commande électromécanique permet d'obtenir des circuits logiques à très faible consommation électrique. En particulier, cela permet d'éliminer les courants de fuite, qui sont un facteur limitant des circuits logiques adiabatiques classiques, et, en particulier, des circuits logiques adiabatiques réalisés à base de transistors.

Les demandes de brevet susmentionnées décrivent plus particulièrement la réalisation de cellules buffer inverseuses et de cellules buffer non inverseuses, d'un certain nombre de cellules logiques combinatoires de base, ainsi que de cellules de mémorisation, à partir de condensateurs à capacité variable à commande électromécanique.

Il serait souhaitable d'améliorer au moins en partie certains aspects des cellules logiques adiabatiques capacitives connues.

### Résumé de l'invention

L'invention est définie par la revendication indépendante 1.

Ainsi, l'invention prévoit une cellule logique capacitive à commande complémentaire, comportant un dispositif électromécanique à capacité variable comportant une partie fixe et une partie mobile, le dispositif électromécanique comportant des première, deuxième, troisième et quatrième électrodes montées sur la partie fixe, et une cinquième électrode montée sur la partie mobile, dans lequel la première électrode est reliée à une borne d'application d'un premier signal logique d'entrée de la cellule, la deuxième électrode est reliée à une borne d'application d'un deuxième signal logique d'entrée de la cellule, complémentaire du premier signal logique d'entrée, la troisième électrode est reliée à une borne de fourniture d'un premier signal logique de sortie de la cellule, et la quatrième électrode est reliée à une borne de fourniture d'un deuxième signal logique de sortie de la cellule, complémentaire du premier signal logique de sortie.

Selon l'invention, les troisième et cinquième électrodes définissent une première capacité variable en fonction de la position de la partie mobile par rapport à la partie fixe, et les quatrième et cinquième électrodes définissent une deuxième capacité variable en fonction de la position de la partie mobile par rapport à la partie fixe.

Selon l'invention, la position de la partie mobile par rapport à la partie fixe est fonction de l'état des premier et deuxième signaux logiques d'entrée complémentaires appliqués respectivement sur les première et deuxième électrodes.

Selon un mode de réalisation, la partie mobile est mobile par rapport à la partie fixe de façon à faire varier la distance entre les troisième et cinquième électrodes et la distance entre les quatrième et cinquième électrodes sans faire varier la surface de la troisième électrode en vis-à-vis de la cinquième électrode ni la surface de la quatrième électrode en vis-à-vis de la cinquième électrode.

Selon un mode de réalisation, la partie mobile est mobile par rapport à la partie fixe de façon à faire varier la surface de la cinquième électrode en vis-à-vis de la troisième électrode et la surface de la cinquième électrode en vis-à-vis de la quatrième électrode sans faire varier la distance entre les troisième et cinquième électrodes ni la distance entre les quatrième et cinquième électrodes.

Selon un mode de réalisation, la cellule comprend en outre une borne d'application d'une tension d'alimentation variable périodique et une borne d'application d'un potentiel de référence.

Selon un mode de réalisation, la cinquième électrode est connectée à la borne d'application du potentiel de référence, et les troisième et quatrième électrodes sont reliées à la borne d'application de la tension d'alimentation variable périodique par l'intermédiaire respectivement de premier et deuxième condensateurs à capacité fixe.

Selon un mode de réalisation, le dispositif électromécanique à capacité variable comprend une sixième électrode montée sur la partie mobile, la sixième électrode étant connectée à la borne d'application du potentiel de référence et la cinquième électrode étant connectée à la borne d'application de la tension d'alimentation variable périodique.

Selon un mode de réalisation, la partie mobile comprend une poutre flexible ancrée à au moins l'une de ses extrémités sur un support fixe.

Selon un mode de réalisation, la partie mobile comprend un élément bistable mécanique.

Selon un mode de réalisation, les troisième, quatrième et cinquième électrodes sont en forme de peignes interdigités.

Selon un mode de réalisation, le dispositif électromécanique comporte en outre des septième et huitième électrodes montées sur la partie fixe, la septième électrode étant reliée à une borne d'application d'un troisième signal logique d'entrée de la cellule et la huitième électrode étant reliée à une borne d'application d'un quatrième signal logique d'entrée de la cellule, complémentaire du troisième signal logique d'entrée.

Selon un mode de réalisation, le dispositif électromécanique comporte en outre des neuvième et dixième électrodes montées sur la partie fixe, la neuvième électrode étan reliée à une borne d'application d'un troisième signal logique d'entrée de la cellule et la huitième électrode étant reliée à une borne d'application d'un quatrième signal logique d'entrée de la cellule, complémentaire du troisième signal logique d'entrée.

Un autre mode de réalisation prévoit un circuit logique comportant des première et deuxièmes cellules logiques telles que définies ci-dessus, dans lequel la première cellule a sa borne de fourniture du premier signal logique de sortie et sa borne de fourniture du deuxième signal logique de sortie reliées respectivement à la borne d'application du premier signal logique d'entrée et à la borne d'application du deuxième signal logique d'entrée de la deuxième cellule.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre schématiquement un condensateur à capacité variable à quatre électrodes qui n'est pas couvert par l'invention ;
la figure 2 est un schéma électrique d'un exemple d'une cellule buffer en logique adiabatique capacitive qui n'est pas couverte par l'invention ;
la figure 3 est un chronogramme illustrant le fonctionnement de la cellule de la figure 2 ;
la figure 4 illustre schématiquement un exemple d'une cellule buffer en logique adiabatique capacitive selon un mode de réalisation ;
la figure 5 est un chronogramme illustrant le fonctionnement de la cellule de la figure 4 ;
la figure 6 illustre schématiquement un dispositif à capacité variable à six électrodes ;
la figure 7 est un schéma électrique d'un exemple de réalisation de la cellule buffer de la figure 4 au moyen du dispositif à capacité variable de la figure 6 ;
la figure 8 illustre schématiquement un dispositif à capacité variable à cinq électrodes ;
la figure 9 est un schéma électrique d'un exemple de réalisation de la cellule buffer de la figure 4 au moyen du dispositif à capacité variable de la figure 8 ;
la figure 10 illustre schématiquement un exemple de réalisation du dispositif à capacité variable à six électrodes de la figure 6 ;
la figure 11 illustre schématiquement un exemple de réalisation du dispositif à capacité variable à cinq électrodes de la figure 8 ;
la figure 12A illustre plus en détail un autre exemple de réalisation du dispositif à capacité variable à cinq électrodes de la figure 8 ;
la figure 12B illustre le fonctionnement du dispositif de la figure 12A ;
la figure 12C illustre le fonctionnement du dispositif de la figure 12A ;
la figure 13 illustre schématiquement un exemple d'une cellule combinatoire en logique adiabatique capacitive selon un mode de réalisation ;
la figure 14 illustre schématiquement un exemple de réalisation d'un dispositif à capacité variable à sept électrodes pour la réalisation d'une cellule combinatoire du type décrit en relation avec la figure 13 ;
la figure 15 illustre plus en détail un autre exemple de réalisation d'un dispositif à capacité variable à sept électrodes pour la réalisation d'une cellule combinatoire du type décrit en relation avec la figure 13 ;
la figure 16 illustre schématiquement un autre exemple de réalisation d'un dispositif à capacité variable à sept électrodes pour la réalisation d'une cellule combinatoire du type décrit en relation avec la figure 13 ;
la figure 17 illustre plus en détail un autre exemple de réalisation d'un dispositif à capacité variable à sept électrodes pour la réalisation d'une cellule combinatoire du type décrit en relation avec la figure 13 ;
la figure 18 illustre un exemple de réalisation d'un dispositif à capacité variable à cinq électrodes pour la réalisation d'une cellule de mémorisation en logique adiabatique capacitive selon un mode de réalisation ;
la figure 19 illustre plus en détail un autre exemple de réalisation du dispositif à capacité variable à cinq électrodes de la figure 8 ;
la figure 20 illustre plus en détail un autre exemple de réalisation du dispositif à capacité variable à six électrodes de la figure 6 ;
la figure 21 illustre de façon schématique un autre exemple d'une cellule logique capacitive selon un mode de réalisation ; et
la figure 22 illustre une variante de réalisation de la cellule de la figure 21.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des dispositifs à capacité variable à commande électromécanique des cellules logiques décrites n'a pas été détaillée. La réalisation de tels dispositifs est à la portée de la personne du métier à partir des indications de la présente description, par exemple en utilisant des procédés connus de réalisation de systèmes micro-électromécaniques (MEMS) .

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la présente description, on entend par plaque, poutre ou région conductrice une plaque, poutre ou région en un matériau apte à conduire des charges électriques, ce matériau pouvant être un matériau conducteur, par exemple un métal, ou encore un matériau semiconducteur, par exemple du silicium.

Dans les exemples décrits ci-après, les signaux logiques d'entrée et de sortie d'une cellule logique correspondent à des tensions variables périodiques, dont l'amplitude détermine la valeur, haute ou basse, du signal logique. On parle aussi de logique impulsionnelle ou logique dynamique dans la mesure où les états des signaux logiques ne sont disponibles que pendant une fraction de la période d'un signal d'horloge formé par la tension d'alimentation de la cellule. Sauf précision contraire, on entend par signal logique un signal ne pouvant prendre que deux états, un état haut (1 logique), correspondant par exemple à une amplitude de tension proche de l'amplitude de la tension d'alimentation de la cellule, par exemple comprise entre 1 et 5 volts, ou un état bas (0 logique), correspondant à une amplitude de tension inférieure à celle de l'état haut, par exemple à une amplitude de tension proche de 0 volt, par exemple inférieure à 0,5 volt.

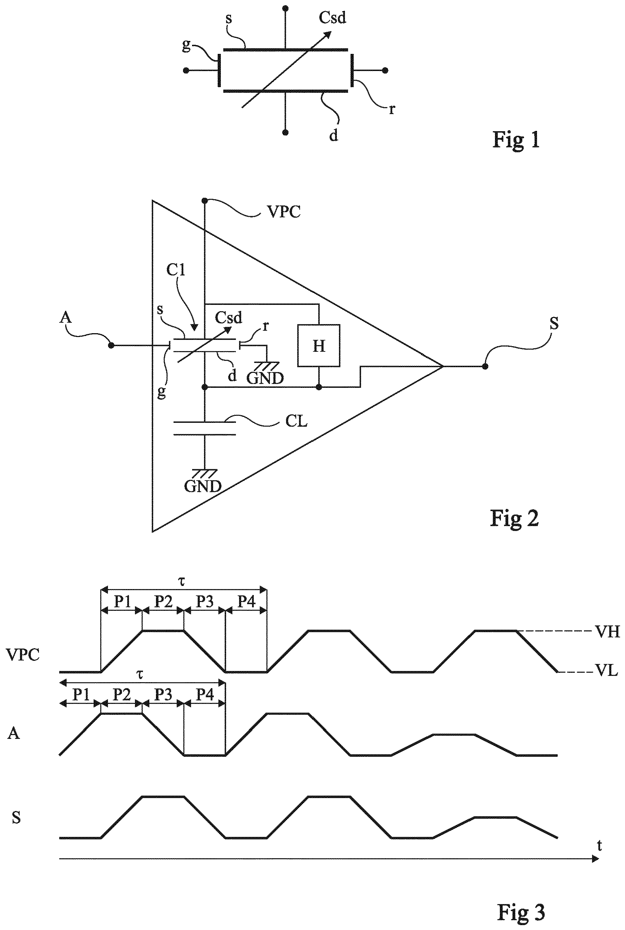

La figure 1 illustre schématiquement un exemple, qui n'est pas couvert par l'invention, d'un condensateur à capacité variable à quatre électrodes du type décrit dans les demandes de brevet susmentionnées, pouvant être utilisé pour réaliser une cellule logique adiabatique capacitive. Le condensateur de la figure 1 comprend deux électrodes principales s et d séparées par une région diélectrique, et deux électrodes de commande g et r isolées électriquement des électrodes principales s et d, adaptées à recevoir un signal de commande pour faire varier la capacité Csd entre les électrodes principales s et d. Les demandes de brevet susmentionnées décrivent plus particulièrement des exemples de réalisation de condensateurs à capacité variable à quatre électrodes de type électromécanique, c'est-à-dire dans lesquels les électrodes principales s et d sont mobiles l'une par rapport à l'autre, et le signal de commande appliqué entre les électrodes r et g permet de faire varier la position relative des électrodes s et d de façon à faire varier la capacité Csd. Le condensateur de la figure 1 est un condensateur à variation positive de capacité, c'est-à-dire que la capacité Csd entre ses électrodes principales s et d est une fonction croissante du signal appliqué entre ses électrodes de commande g et r. Ceci est schématisé par une flèche oblique pointant vers le haut dans la représentation de la figure 1.

La figure 2 est un schéma électrique d'un exemple, , pas couvert par l'invention, d'une cellule buffer en logique adiabatique capacitive. La cellule buffer de la figure 2 comprend un condensateur à capacité variable à quatre électrodes C1. Le condensateur C1 est un condensateur à variation positive de capacité, par exemple du type décrit en relation avec la figure 1. L'électrode principale s du condensateur C1 est reliée, par exemple connectée, à une borne d'application d'une tension d'alimentation VPC de la cellule, référencée par rapport à un noeud GND d'application d'un potentiel de référence de la cellule, par exemple connecté à la masse. L'électrode principale d du condensateur C1 est reliée, par exemple connectée, à une borne de fourniture d'une tension de sortie S de la cellule, référencée par rapport au noeud GND. L'électrode de commande g du condensateur C1 est reliée, par exemple connectée, à une borne d'application d'une tension d'entrée A de la cellule, référencée par rapport au noeud GND. L'électrode de commande r du condensateur C1 est reliée, par exemple connectée, au noeud GND. Par souci de simplification, dans la présente description, on désignera par les mêmes références les bornes d'application ou de fourniture des signaux, et les signaux correspondants.

Sur la figure 2, un condensateur CL connecté entre le noeud de sortie S et le noeud de référence GND a été représenté, schématisant la capacité de sortie de la cellule. En pratique, la capacité de sortie CL peut ne pas comprendre de composant spécifiquement réalisé et connecté au noeud de sortie S, mais correspondre à la somme des capacités des différents éléments reliés au noeud S, notamment des pistes d'interconnexion, ou encore une autre cellule logique capacitive (non représentée) dont l'entrée peut être reliée au noeud S.

Dans l'exemple de la figure 2, la cellule buffer comprend en outre un dispositif de maintien H adapté à maintenir la tension de sortie S de la cellule à un niveau haut lors de phases de transition de la tension d'entrée A de la cellule d'un niveau haut à un niveau bas.

La figure 3 est un diagramme illustrant le fonctionnement de la cellule de la figure 2. Plus particulièrement, la figure 3 illustre l'évolution, en fonction du temps t (en abscisse), de la tension d'alimentation VPC, de la tension d'entrée A, et de la tension de sortie S de la cellule de la figure 2.

La tension d'alimentation VPC est une tension variable périodique, fournie par une source de tension variable non représentée en figure 2. La tension VPC varie de façon périodique et continue entre une valeur basse VL, par exemple comprise entre 0 et 2 volts, et une valeur haute VH supérieure à VL, par exemple comprise entre 1 et 10 volts. Dans l'exemple représenté, la tension d'alimentation VPC est une tension trapézoïdale. Plus particulièrement, dans cet exemple, chaque période τ de la tension VPC comprend quatre phases successives P1, P2, P3 et P4 sensiblement de même durée T=τ/4. Lors de la phase P1, la tension VPC croit linéairement depuis sa valeur basse VL jusqu'à sa valeur haute VH. Lors de la phase P2, la tension VPC reste sensiblement constante et égale à sa valeur haute VH. Lors de la phase P3, la tension VPC décroit linéairement depuis sa valeur haute VH jusqu'à sa valeur basse VL. Lors de la phase P4, la tension VPC reste sensiblement constante et égale à sa valeur basse VL.

Les tensions A et S sont synchronisées sur la tension d'alimentation VPC, qui sert aussi de signal d'horloge. Les tensions A et S présentent une variation périodique de forme sensiblement identique à celle de la tension d'alimentation variable VPC. Les tensions A et S définissent respectivement des signaux logiques d'entrée et de sortie de la cellule. Le signal logique d'entrée, respectivement de sortie, est à un état haut lorsque l'amplitude de la tension variable périodique A, respectivement S, est à un niveau haut, par exemple proche de l'amplitude de la tension d'alimentation VPC, et est à un niveau bas lorsque l'amplitude de la tension variable périodique A, respectivement S, est à un niveau bas, par exemple proche de 0 volts. La tension A présente une avance de phase de l'ordre de T=τ/4 sur la tension d'alimentation VPC. La tension S est quant à elle en phase avec la tension d'alimentation VPC.

Dans l'exemple représenté en figure 3, le signal d'entrée A est à l'état haut pendant deux périodes τ successives du signal d'alimentation VPC, puis passe à l'état bas.

La tension de sortie S dépend du rapport entre la capacité variable Csd du condensateur C1 commandé par la tension d'entrée A, et la capacité fixe CL. Pour un 0 logique du signal d'entrée A (tension A d'amplitude proche de 0 volts), la capacité Csd du condensateur C1 reste à une valeur basse CsdL, et l'impulsion de tension S transmise sur la borne de sortie S de la cellule est à un niveau d'amplitude bas, par exemple proche de 0 volts. Pour un 1 logique du signal d'entrée A (tension A d'amplitude proche de l'amplitude de la tension d'alimentation VPC), la capacité Csd du condensateur C1 augmente jusqu'à une valeur haute CsdH, et on obtient sur la borne de sortie S de la cellule (par le pont diviseur capacitif formé par les capacités Csd et CL) une impulsion de tension S présentant un niveau d'amplitude haut, par exemple proche de l'amplitude de la tension d'alimentation VPC. Le dispositif de maintien H interne à la cellule buffer permet de maintenir entre les bornes d'alimentation VPC et de sortie S de la cellule, pendant la phase de décroissance de l'impulsion de niveau haut de la tension d'entrée A de la cellule (phase P3 de la tension A, correspondant à la phase P2 de la tension VPC), une capacité sensiblement égale à la valeur haute CsdH de capacité du condensateur C1, ce qui permet de fournir en sortie de la cellule une impulsion de niveau haut de même forme (trapézoïdale dans cette exemple) que la tension d'alimentation VPC.

En pratique, la tension d'alimentation trapézoïdale VPC peut être approximée par une tension sinusoïdale de période τ.

On notera que la cellule buffer décrite en relation avec les figures 2 et 3 est une cellule buffer non inverseuse, c'est-à-dire qu'elle recopie sur sa borne de sortie un signal S ayant le même état logique que le signal A appliqué sur sa borne d'entrée. De façon similaire, on peut réaliser une cellule buffer inverseuse en logique adiabatique capacitive, en remplaçant simplement, dans l'exemple de la figure 2, le condensateur à variation positive de capacité C1 par un condensateur à variation négative de capacité.

Plus généralement, diverses fonctions logiques de base, et en particulier les fonctions ET, OU, NON OU, NON ET, ou encore des fonctions de mémorisation, peuvent être réalisées en logique adiabatique capacitive au moyen d'un ou plusieurs condensateurs à capacité variable à quatre électrodes à commande électromécanique, à variation positive de capacité et/ou à variation négative de capacité, comme cela a été décrit dans les demandes de brevet susmentionnées.

On cherche ici à améliorer certains aspects des cellules logiques adiabatiques capacitives décrites dans les demandes de brevet susmentionnées.

Selon un aspect des modes de réalisation décrits, on prévoit ici d'implémenter des cellules logiques adiabatiques à commande complémentaire, c'est-à-dire des cellules comprenant deux bornes d'entrée distinctes recevant respectivement un premier signal logique d'entrée et un deuxième signal logique d'entrée complémentaire du premier signal, et deux bornes de sortie distinctes fournissant respectivement un premier signal logique de sortie et un deuxième signal logique de sortie complémentaire du premier signal. Chaque cellule est implémentée au moyen d'un unique dispositif micro-électromécanique à capacité variable comportant une partie fixe et une partie mobile. L'utilisation de signaux logiques complémentés pour piloter un même dispositif micro-électromécanique permet de diminuer significativement les niveaux de tension nécessaires pour faire basculer le dispositif entre ses deux états.

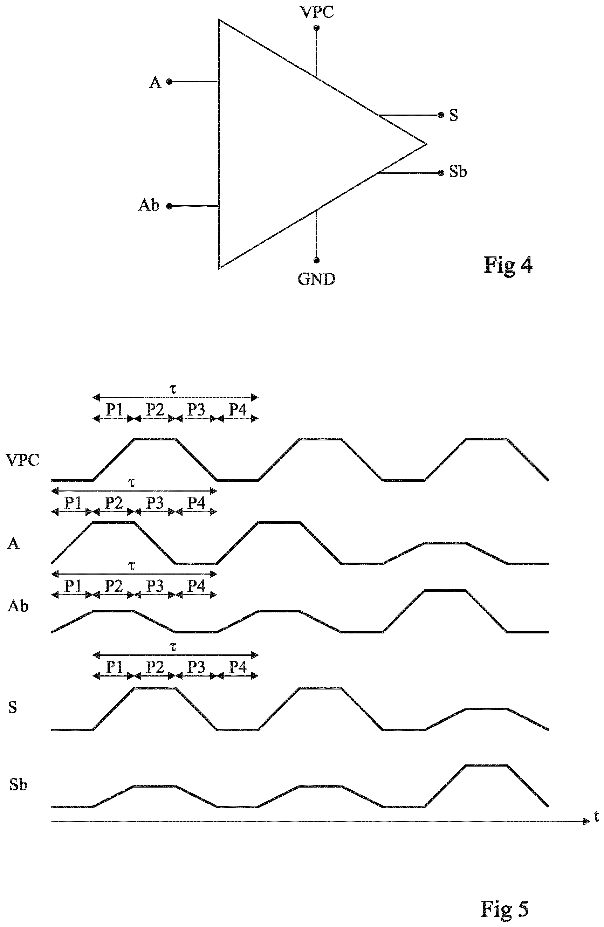

La figure 4 illustre schématiquement un exemple d'une cellule buffer à commande complémentaire en logique adiabatique capacitive.

La cellule de la figure 4 comprend deux bornes d'entrée destinées à recevoir respectivement un premier signal logique d'entrée A, et un deuxième signal logique d'entrée Ab, complémentaire du signal A. La cellule de la figure 4 comprend en outre deux bornes de sortie destinées à fournir respectivement un premier signal logique de sortie S, et un deuxième signal logique de sortie Sb, complémentaire du signal S. La cellule de la figure 4 comprend en outre une borne d'application d'une tension d'alimentation VPC de la cellule, référencée par rapport à un noeud GND d'application d'un potentiel de référence de la cellule, par exemple connecté à la masse.

La figure 5 est un diagramme illustrant le fonctionnement de la cellule de la figure 4. Plus particulièrement, la figure 5 illustre l'évolution, en fonction du temps t (en abscisse), de la tension d'alimentation VPC, des tensions d'entrée A et Ab, et des tensions de sortie S et Sb de la cellule de la figure 4.

La tension d'alimentation VPC est une tension variable périodique identique ou similaire à ce qui a été décrit ci-dessus en relation avec la figure 3. De même, les tensions A et S sont identiques ou similaires à ce qui a été décrit ci-dessus en relation avec la figure 3.

Les tensions Ab et Sb sont elles aussi synchronisées sur la tension d'alimentation VPC, et présentent chacune une variation périodique de forme sensiblement identique à celle de la tension d'alimentation variable VPC. Les tensions Ab et Sb définissent respectivement un signal logique d'entrée complémentaire du signal A et un signal logique de sortie complémentaire du signal S. Autrement dit, le signal Ab est à l'état bas lorsque le signal A est à l'état haut, et à l'état haut lorsque le signal A est à l'état bas. De façon similaire, le signal Sb est à l'état bas lorsque le signal S est à l'état haut, et à l'état haut lorsque le signal Sb est à l'état bas. De même que la tension A, la tension Ab présente une avance de phase de l'ordre de T=τ/4 sur la tension d'alimentation VPC. La tension Sb est quant à elle en phase avec la tension d'alimentation VPC.

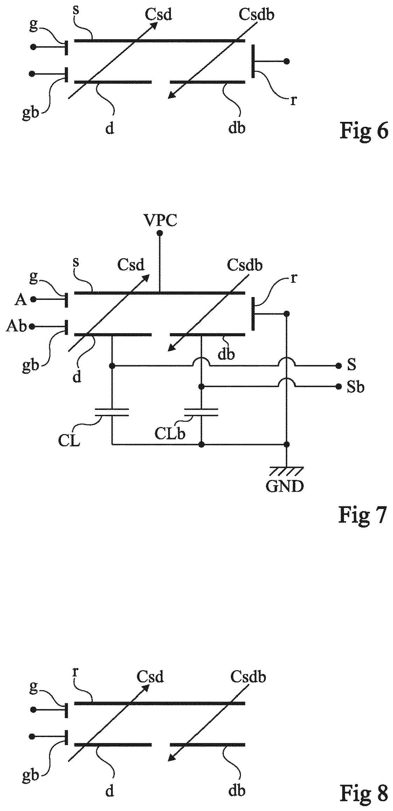

La figure 6 illustre schématiquement un dispositif micro-électromécanique à capacité variable à six électrodes pouvant être utilisé pour réaliser une cellule logique adiabatique capacitive à commande complémentaire du type décrit en relation avec la figure 4.

Le dispositif de la figure 6 comprend trois électrodes principales s, d et db, isolées électriquement les unes des autres. Les électrodes s et d définissent une première capacité variable Csd du dispositif. Les électrodes s et db définissent une deuxième capacité variable Csdb du dispositif. Le dispositif de la figure 6 comprend en outre deux électrodes de commande g et gb isolées électriquement l'une de l'autre et isolées électriquement des électrodes principales, adaptées à recevoir des signaux de commande pour faire varier les capacités Csd et Csdb. Le dispositif de la figure 6 comprend en outre une électrode de référence r, à laquelle sont référencés les signaux appliqués sur les électrodes g et gb.

Le dispositif de la figure 6 est un dispositif à commande électromécanique comprenant une partie fixe et une partie mobile (par rapport à la partie fixe). Dans cet exemple, les électrodes g, gb, d et db sont montées sur la partie fixe, et les électrodes s et r sont montées sur la partie mobile. Les signaux de commande appliqués entre les électrodes g et r d'une part, et entre les électrodes gb et r d'autre part, permettent de faire varier la position relative de l'électrode s par rapport aux électrodes d et db, et ainsi la valeur des capacités Csd et Csdb (de façon complémentaire). Plus particulièrement, dans cet exemple, lorsqu'un signal logique de niveau haut et un signal logique de niveau bas (référencés par rapport à l'électrode r) sont appliqués respectivement sur les électrodes g et gb, les capacités Csd et Csdb prennent respectivement une valeur haute CsdH et une valeur basse CsdbL. A l'inverse, lorsqu'un signal logique de niveau bas et un signal logique de niveau haut sont appliqués respectivement sur les électrodes g et gb, les capacités Csd et Csdb prennent respectivement une valeur basse CsdL, par exemple sensiblement égale à la valeur CsdbL, et une valeur haute CsdbH, par exemple sensiblement égale à la valeur CsdH.

Des exemples de réalisation du dispositif de la figure 6 seront décrits plus en détail ci-après.

La figure 7 est un schéma électrique d'un exemple de réalisation de la cellule buffer de la figure 4 au moyen du dispositif à capacité variable de la figure 6.

Dans cet exemple, l'électrode principale s du dispositif de la figure 6 est reliée, par exemple connectée, à une borne d'application de la tension d'alimentation VPC de la cellule. Les électrodes principales d et db du dispositif de la figure 6 sont reliées, par exemple connectées, respectivement à une borne de fourniture du signal de sortie S et à une borne de fourniture du signal de sortie Sb de la cellule. Les tensions S et Sb définissant les signaux logiques de sortie de la cellule sont référencées par rapport au noeud GND. Les électrodes de commande g et gb du dispositif de la figure 6 sont reliées, par exemple connectées, respectivement à une borne d'application du signal d'entrée A de la cellule, et à une borne d'application du signal d'entrée Ab de la cellule. Les tensions A et Ab définissant les signaux logiques d'entrée de la cellule sont référencées par rapport au noeud GND. L'électrode de référence r du dispositif de la figure 6 est reliée, par exemple connectée, au noeud GND.

Sur la figure 7, un condensateur CL et un condensateur CLb, connectés respectivement entre le noeud de sortie S et le noeud de référence GND et entre le noeud de sortie Sb et le noeud de référence GND, ont été représentés, schématisant les capacités de sortie de la cellule. En pratique, les capacités de sortie CL et CLb peuvent ne pas comprendre des composants spécifiquement réalisés et connectés aux noeuds de sortie S et Sb, mais correspondre à la somme des capacités des différents éléments reliés au noeud S, respectivement au noeud Sb, notamment des pistes d'interconnexion, ou encore une autre cellule logique capacitive (non représentée) à commande complémentaire dont les entrées complémentées peuvent être reliées respectivement aux noeuds S et Sb.

On notera que la cellule buffer décrite en relation avec la figure 7 est une cellule buffer non inverseuse, c'est-à-dire qu'elle recopie sur ses deux bornes de sortie S et Sb des signaux ayant respectivement le même état logique que les signaux complémentaires appliqués sur ses bornes d'entrée A et Ab. De façon similaire, on peut réaliser une cellule buffer inverseuse en logique adiabatique capacitive à commande complémentaire, en inversant les bornes d'entrée A et Ab (c'est-à-dire en connectant les bornes A et Ab respectivement aux électrodes gb et g) ou les bornes de sorties S et Sb (c'est-à-dire en connectant les bornes S et Sb respectivement aux électrodes db et d), ou en remplaçant le dispositif à variation de capacité positive de la figure 6 par un dispositif à variation de capacité négative.

La figure 8 illustre schématiquement un dispositif micro-électromécanique à capacité variable à cinq électrodes pouvant être utilisé pour réaliser une cellule logique adiabatique capacitive à commande complémentaire, par exemple du type décrit en relation avec la figure 4. Le dispositif de la figure 8 diffère du dispositif de la figure 6 principalement en ce que, dans le dispositif de la figure 8, les électrodes s et r sont confondues. L'électrode correspondante sera désignée par la référence r dans la description relative à la figure 8.

Ainsi, le dispositif de la figure 8 comprend deux électrodes principales d et db, isolées électriquement l'une de l'autre, et une électrode de référence r isolée électriquement des électrodes d et db. Les électrodes r et d définissent une première capacité variable Csd du dispositif. Les électrodes r et db définissent une deuxième capacité variable Csdb du dispositif. Le dispositif de la figure 8 comprend en outre deux électrodes de commande g et gb isolées électriquement l'une de l'autre et isolées électriquement des électrodes principales d, db et r, adaptées à recevoir des signaux de commande pour faire varier les capacités Csd et Csdb. Les signaux appliqués sur les électrodes g et gb sont référencés par rapport à l'électrode r.

Le dispositif de la figure 8 est un dispositif à commande électromécanique comprenant une partie fixe et une partie mobile. Dans cet exemple, les électrodes g, gb, d et db sont montées sur la partie fixe, et l'électrode r est montée sur la partie mobile. Les signaux de commande appliqués entre les électrodes g et r d'une part, et entre les électrodes gb et r d'autre part, permettent de faire varier la position relative de l'électrode r par rapport aux électrodes d et db, et ainsi la valeur des capacités Csd et Csdb. Plus particulièrement, dans cet exemple, lorsqu'un signal logique de niveau haut et un signal logique de niveau bas (référencés par rapport à l'électrode r) sont appliqués respectivement sur les électrodes g et gb, les capacités Csd et Csdb prennent respectivement une valeur haute CsdH et une valeur basse CsdbL. A l'inverse, lorsqu'un signal logique de niveau bas et un signal logique de niveau haut sont appliqués respectivement sur les électrodes g et gb, les capacités Csd et Csdb prennent respectivement une valeur basse CsdL, par exemple sensiblement égale à la valeur CsdbL, et une valeur haute CsdbH, par exemple sensiblement égale à la valeur CsdH.

Des exemples de réalisation du dispositif de la figure 8 seront décrits plus en détail ci-après.

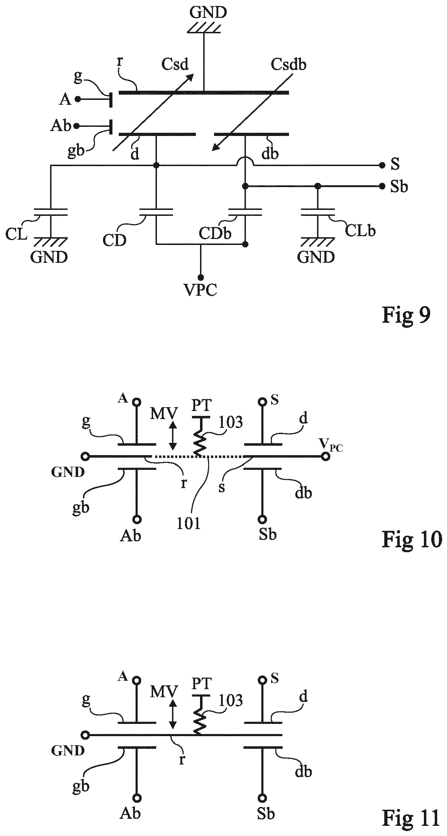

La figure 9 est un schéma électrique d'un exemple de réalisation de la cellule buffer de la figure 4 au moyen du dispositif à capacité variable de la figure 8.

Dans cet exemple, la cellule comprend deux capacités de fixes CD et CDb, par exemple identiques ou similaires (aux dispersions de fabrication près). La tension d'alimentation VPC de la cellule est appliquée sur les électrodes principales d et db du dispositif de la figure 8 respectivement par l'intermédiaire des capacités CD et CDb. Plus particulièrement, la capacité CD a une première électrode reliée, par exemple connectée, à l'électrode d et une deuxième électrode reliée, par exemple connectée, à la borne d'application de la tension VPC. La capacité CDb a une première électrode reliée, par exemple connectée, à l'électrode db et une deuxième électrode reliée, par exemple connectée, à la borne d'application de la tension VPC.

Les électrodes principales d et db du dispositif de la figure 8 sont par ailleurs reliées, par exemple connectées, respectivement à une borne de fourniture du signal de sortie S et à une borne de fourniture du signal de sortie Sb de la cellule. Les électrodes de commande g et gb du dispositif de la figure 8 sont reliées, par exemple connectées, respectivement à une borne d'application du signal d'entrée A de la cellule, et à une borne d'application du signal d'entrée Ab de la cellule. L'électrode de commande r du dispositif de la figure 8 est reliée, par exemple connectée, au noeud GND. Dans cet exemple, les tensions A, Ab, S, Sb et VPC sont référencées par rapport au noeud GND.

Sur la figure 9, un condensateur CL et un condensateur CLb, connectés respectivement entre le noeud de sortie S et le noeud de référence GND et entre le noeud de sortie Sb et le noeud de référence GND, ont été représentés, schématisant les capacités de sortie de la cellule. En pratique, les capacités de sortie CL et CLb peuvent ne pas comprendre des composants spécifiquement réalisés et connectés aux noeuds de sortie S et Sb, mais correspondre à la somme des capacités des différents éléments reliés au noeud S, respectivement au noeud Sb, notamment des pistes d'interconnexion, ou encore une autre cellule logique capacitive (non représentée) à commande complémentaire dont les entrées complémentées peuvent être reliées respectivement aux noeuds S et Sb.

Comme dans l'exemple de la figure 7, la cellule buffer décrite en relation avec la figure 9 est une cellule buffer non inverseuse. De façon similaire, on peut réaliser une cellule buffer inverseuse en logique adiabatique capacitive à commande complémentaire, en inversant les bornes d'entrée A et Ab ou les bornes de sorties S et Sb, ou remplaçant le dispositif à variation de capacité positive de la figure 8 par un dispositif à variation négative de capacité.

Un avantage de la cellule de la figure 9 réside dans le fait qu'un dispositif micro-électromécanique à capacité variable à cinq électrodes du type décrit en relation avec la figure 8 est plus simple à réaliser qu'un dispositif à six électrodes du type décrit en relation avec la figure 6. En contrepartie, des condensateurs CD et CDb doivent être prévus.

Plus généralement, diverses fonctions logiques de base, et en particulier les fonctions ET, OU, NON OU, NON ET, ou encore des fonctions de mémorisation, peuvent être réalisées en logique adiabatique capacitive à commande complémentaire au moyen d'un unique dispositif micro-électromécanique à capacité variable du type décrit en relation avec la figure 6 ou 8. Des exemples de réalisation de telles fonctions seront décrits plus en détail ci-après.

La figure 10 illustre schématiquement un exemple de réalisation du dispositif à capacité variable à six électrodes de la figure 6.

Le dispositif de la figure 10 comprend une structure fixe sur laquelle sont montées les électrodes fixes g, gb, d et db, et une structure mobile sur laquelle sont montées les électrodes mobiles r et s. Dans cet exemple, les électrodes g, gb, d, db, s et r ont chacune la forme d'une plaque conductrice sensiblement plane. Dans cet exemple, les électrodes g, gb, d, db, s et r sont sensiblement parallèles entre elles. Les électrodes g et gb sont disposées en vis à vis l'une de l'autre, c'est-à-dire qu'elles présentent une surface commune en projection selon un axe orthogonal aux plaques conductrices. L'électrode r est disposée entre les électrodes g et gb, en vis-à-vis des électrodes g et gb. De façon similaire, les électrodes d et db sont disposées en vis à vis l'une de l'autre, et l'électrode s est disposée entre les électrodes d et db, en vis-à-vis des électrodes d et db. Dans l'exemple représenté, les électrodes g et d d'une part, et gb et db d'autre part, sont sensiblement coplanaires. De plus, dans cet exemple, les électrodes r et s sont sensiblement coplanaires. Les modes de réalisation décrits ne se limitent toutefois pas à ce cas particulier. Dans l'exemple de la figure 10, la structure mobile comprend un élément 101 électriquement isolant, reliant mécaniquement les électrodes mobiles r et s en les isolant électriquement l'une de l'autre. Dans cet exemple, l'ensemble comprenant les électrodes mobiles r et s et l'élément électriquement isolant 101 est relié mécaniquement à un point PT de la structure fixe, aussi appelé point d'ancrage, par l'intermédiaire d'un ressort 103.

Dans l'exemple de la figure 10, la structure mobile est adaptée à se déplacer selon une direction MV orthogonale aux électrodes g, gb, r, d, db et s, sous l'effet de la force électrostatique exercée par l'électrode g ou gb sur l'électrode r. Plus particulièrement, dans l'exemple représenté, lorsqu'une tension de niveau haut est appliquée sur l'électrode g et qu'une tension de niveau bas est appliquée sur l'électrode gb (signaux A et Ab respectivement à l'état haut et à l'état bas), l'électrode r est attirée vers l'électrode g par effet électrostatique. Il en résulte que l'électrode s se rapproche de l'électrode d et s'éloigne de l'électrode db. Ainsi, la capacité Csd (entre l'électrode s et l'électrode d) augmente et la capacité Csdb (entre l'électrode s et l'électrode db) diminue. A l'inverse, lorsqu'une tension de niveau bas est appliquée sur l'électrode g et qu'une tension de niveau haut est appliquée sur l'électrode gb (signaux A et Ab respectivement à l'état bas et à l'état haut), l'électrode r est attirée vers l'électrode gb par effet électrostatique. Il en résulte que l'électrode s se rapproche de l'électrode db et s'éloigne de l'électrode d. Ainsi, la capacité Csd diminue et la capacité Csdb augmente. Des couches électriquement isolantes, non représentées, peuvent être prévues entre les électrodes mobiles et les électrodes fixes pour éviter tout risque de court-circuit entre lesdites électrodes.

La figure 11 illustre schématiquement un exemple de réalisation du dispositif à capacité variable à cinq électrodes de la figure 5.

Le dispositif de la figure 11 diffère du dispositif de la figure 10 essentiellement en ce que, dans l'exemple de la figure 11, l'ensemble comprenant l'électrode s, l'électrode r et l'élément électriquement isolant 101 (figure 10), est remplacé par une plaque conductrice unique formant l'électrode r. Ainsi, dans cet exemple, l'électrode r est disposée entre les électrodes g et gb, en vis-à-vis des électrodes g et gb, et s'étend en outre entre les électrodes d et db, en vis-à-vis des électrodes d et db. Dans cet exemple, l'électrode mobile r est reliée mécaniquement à un point PT de la structure fixe par l'intermédiaire d'un ressort 103.

Comme dans l'exemple de la figure 10, la structure mobile est adaptée à se déplacer selon une direction MV orthogonale aux électrodes g, gb, r, d et db, sous l'effet de la force électrostatique exercée par l'électrode g ou gb sur l'électrode r. Plus particulièrement, dans l'exemple représenté, lorsqu'une tension de niveau haut est appliquée sur l'électrode g et qu'une tension de niveau bas est appliquée sur l'électrode gb (signaux A et Ab respectivement à l'état haut et à l'état bas), l'électrode r est attirée vers l'électrode g par effet électrostatique. Il en résulte que l'électrode r se rapproche de l'électrode d et s'éloigne de l'électrode db. Ainsi, la capacité Csd (entre l'électrode r et l'électrode d) augmente et la capacité Csdb (entre l'électrode r et l'électrode db) diminue. A l'inverse, lorsqu'une tension de niveau bas est appliquée sur l'électrode g et qu'une tension de niveau haut est appliquée sur l'électrode gb (signaux A et Ab respectivement à l'état bas et à l'état haut), l'électrode r est attirée vers l'électrode gb par effet électrostatique. Il en résulte que l'électrode r se rapproche de l'électrode db et s'éloigne de l'électrode d. Ainsi, la capacité Csd diminue et la capacité Csdb augmente.

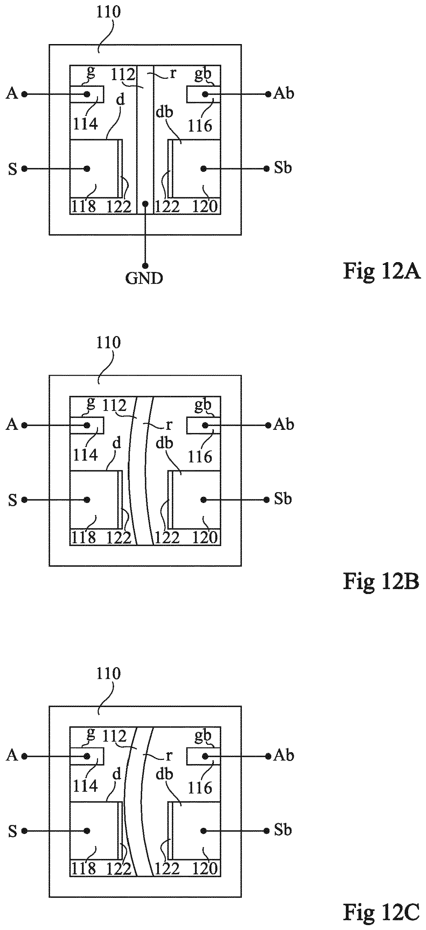

La figure 12A illustre plus en détail un autre exemple de réalisation du dispositif à capacité variable à cinq électrodes de la figure 8.

Le dispositif de la figure 12A comprend un cadre support fixe 110. Dans cet exemple, l'électrode mobile r est formée par une poutre conductrice flexible 112, ancrée, à au moins l'une de ses extrémités (les deux dans l'exemple représenté), au support 110. Les électrodes de commande g et gb sont formées respectivement par deux régions conductrices 114 et 116, par exemple sensiblement de même forme et de mêmes dimensions, solidaires mécaniquement du cadre support 110 et disposées respectivement de part et d'autre de la poutre 112, à distance de la poutre 112. Les électrodes principales d et db sont formées respectivement par deux régions conductrices 118 et 120, par exemple sensiblement de même forme et de mêmes dimensions, solidaires mécaniquement du cadre support 110 et disposées respectivement de part et d'autre de la poutre 112, à distance de la poutre 112. Dans cet exemple, la région 118 (électrode d) est disposée du même côté de la poutre 112 que la région 114 (électrode g), et la région 120 est disposée du même côté de la poutre 112 que la région 116.

Dans cet exemple, au repos, c'est-à-dire en l'absence de toute polarisation électrique, la distance entre la région 114 (électrode g) et la poutre 112 (électrode r) est sensiblement égale à la distance entre la région 116 (électrode gb) et la poutre 112 (électrode r). Par ailleurs, dans cet exemple, au repos, la distance entre la région 118 (électrode d) et la poutre 112 (électrode r) est sensiblement égale à la distance entre la région 120 (électrode db) et la poutre 112 (électrode r). La figure 12A représente le dispositif dans cette configuration de repos.

Dans l'exemple représenté, en position de repos, la distance entre la région 114 (électrode g) et la poutre flexible 112 (électrode r) est supérieure à la distance entre la région 118 (électrode d) et la poutre 112 (électrode r). De façon similaire, la distance entre la région 116 (électrode gb) et la poutre flexible 112 (électrode r) est supérieure à la distance entre la région 120 (électrode db) et la poutre 112 (électrode r). Par ailleurs, dans l'exemple représenté, la surface des régions 114 et 116 en vis-à-vis de la poutre 112 est inférieure à la surface des régions 118 et 120 en vis-à-vis de la poutre 112.

Dans l'exemple de la figure 12A, la face de la région 118 en vis-à-vis de la poutre 112 et la face de la région 120 en vis-à-vis de la poutre 112 sont revêtues d'une couche diélectrique 122, par exemple en oxyde de silicium, permettant d'éviter les courts-circuits entre les électrodes d ou db et l'électrode r lors des déformations de la poutre 112. A titre de variante, la couche 122 peut recouvrir l'ensemble des électrodes.

Le cadre support 110 peut être en un matériau électriquement isolant, par exemple de l'oxyde de silicium, ou en un matériau conducteur ou semiconducteur, par exemple du silicium. Dans le cas où le cadre 110 est en un matériau conducteur ou semiconducteur, des régions électriquement isolantes, non représentées, peuvent être prévues à l'interface entre les régions 114, respectivement 116, respectivement 118, respectivement 120 et le cadre support 110, de façon à isoler électriquement les électrodes g, gb, d et db du cadre support 110. La poutre flexible 112 peut être reliée électriquement au cadre support 110, ou être isolée électriquement du cadre support 110.

Les figures 12B et 12C représentent le dispositif de la figure 12A dans deux autres configurations de fonctionnement.

A titre d'exemple illustratif, on considère ici que les signaux logiques d'entrée A et Ab sont respectivement à l'état haut et à l'état bas.

Lorsque les tensions A et Ab sont toutes les deux à l'état bas (phase P4 des tensions A et Ab), le dispositif est dans sa position de repos, telle qu'illustrée par la figure 12A. La capacité Csd entre les électrodes d et r est alors sensiblement égale à la capacité Csdb entre les électrodes db et r.

Pendant la phase P1 des tensions A et Ab, la tension A (1 logique) appliquée sur l'électrode g devient supérieure à la tension Ab (0 logique) appliquée sur l'électrode gb. Ainsi, la région 114 crée une force attractive supérieure à la force attractive générée par la région 116. Il en résulte que la poutre flexible 112 se déforme, en se rapprochant des régions 112 et 118 et en s'éloignant des régions 116 et 120. Ceci conduit à augmenter la capacité Csd et à diminuer la capacité Csdb. Cette configuration est illustrée par la figure 12B.

Lors de la phase P2 des tensions A et Ab, la différence entre les tensions A et Ab est maximale. De plus, une impulsion de niveau haut apparait sur l'électrode de sortie d (phase P1 du signal S), tandis que l'électrode de sortie db reste à un niveau bas (phase P1 du signal Sb). Il en résulte que la région 118 créée une force attractive supérieure à la force attractive générée par la région 120. La poutre flexible 112 est ainsi maintenue au plus près de la région 118 et au plus loin de la région 120. La capacité Csd est ainsi à sa valeur haute CsdH et la capacité Csdb est à sa valeur basse CsdbL.

Le système se maintient dans cette position pendant la phase P3 des signaux A et Ab, puis revient à sa position initiale lors de la phase P4 des signaux A et Ab, en récupérant en totalité ou en partie l'énergie de déplacement de la poutre 112 par l'intermédiaire de la tension d'alimentation VPC, assurant un fonctionnement dit adiabatique.

Un fonctionnement similaire (symétrique) est obtenu lorsque les signaux logiques A et Ab sont respectivement à l'état bas et à l'état haut.

On notera que le dispositif de la figure 12A forme un dispositif micro-électromécanique à cinq électrodes pouvant être intégré dans une cellule du type décrit en relation avec la figure 9. A titre de variante, la poutre flexible 112 peut supporter deux électrodes r et s disjointes, disposées respectivement entre les électrodes g et gb et entre les électrodes d et db. On obtient ainsi un dispositif à six électrodes pouvant être intégré dans une cellule du type décrit en relation avec la figure 6 ou 7.

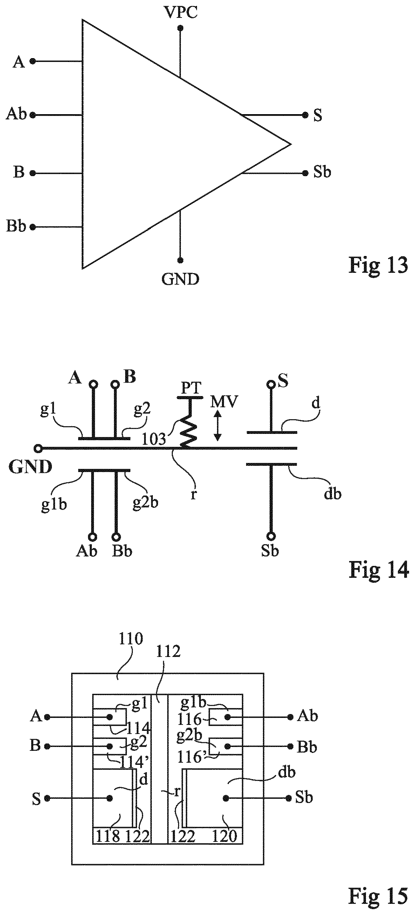

La figure 13 illustre schématiquement un exemple d'une cellule combinatoire en logique adiabatique capacitive selon un mode de réalisation.

La cellule de la figure 13 comprend quatre bornes d'entrée destinées à recevoir respectivement :
- un premier signal logique d'entrée A ;
- un deuxième signal logique d'entrée Ab, complémentaire du signal A ;
- un troisième signal logique d'entrée B, distinct du signal A ; et
- un quatrième signal logique d'entrée Bb, complémentaire du signal B.

La cellule de la figure 13 comprend en outre deux bornes de sortie destinées à fournir respectivement un premier signal logique de sortie S, et un deuxième signal logique de sortie Sb, complémentaire du signal S. La cellule de la figure 13 comprend en outre une borne d'application d'une tension d'alimentation VPC de la cellule, référencée par rapport à un noeud GND d'application d'un potentiel de référence de la cellule.

Les signaux A, Ab et VPC sont identiques ou similaire à ce qui a été décrit ci-dessus en relation avec la figure 5. Les signaux B et Bb sont similaires aux signaux A et Ab, à ceci près qu'ils peuvent avoir des niveaux logiques différents des signaux A et Ab. Autrement dit, les signaux B et Bb définissent un signal logique d'entrée complémenté pouvant prendre des valeurs différentes du signal logique d'entrée complémenté défini par les signaux A et Ab. De même que les signaux A et Ab, les signaux B et Bb sont en avance de phase de l'ordre de T=τ/4 sur la tension d'alimentation VPC. Les signaux S et Sb définissent un signal logique de sortie complémenté, dont l'état logique correspond à une combinaison des signaux logiques d'entrée complémentés A, Ab et B, Bb. Autrement dit, le signal logique S est une combinaison logique des signaux A et B, et le signal Sb est le complément logique du signal S. Comme dans les exemples précédents, les signaux S et Sb sont en phase avec la tension d'alimentation VPC. La fonction logique mise en oeuvre par la cellule de la figure 13 est par exemple une fonction ET, une fonction OU, une fonction NON ET, une fonction NON OU, ou toute autre fonction logique à deux entrées et une sortie.

La figure 14 illustre schématiquement un exemple de réalisation d'un dispositif micro-électromécanique à capacité variable pour la réalisation d'une cellule combinatoire du type décrit en relation avec la figure 13. Dans cet exemple, le dispositif micro-électromécanique est adapté pour la mise en oeuvre d'une fonction OU.

Le dispositif de la figure 14 est un dispositif à sept électrodes. Il comprend une structure fixe sur laquelle sont montées six électrodes fixes g1, g1b, g2, g2b, d et db, et une structure mobile sur laquelle est montée une électrode de référence r. Dans cet exemple, les électrodes g1, g1b, g2, g2b, d, db et r ont chacune la forme d'une plaque conductrice sensiblement plane. Dans cet exemple, les électrodes g1, g1b, g2, g2b, d, db et r sont sensiblement parallèles entre elles. Les électrodes g1 et g1b sont disposées en vis à vis l'une de l'autre. De même, les électrodes g2 et g2b sont disposées en vis-à-vis l'une de l'autre. L'électrode r s'étend entre les électrodes g1 et g1b, en vis-à-vis des électrodes g1 et g1b, et entre les électrodes g2 et g2b, en vis-à-vis des électrodes g2 et g2b. Dans l'exemple de la figure 14, les électrodes g1 et g2 sont disposées du côté de la face supérieure de l'électrode r, et les électrodes g1b et g2b sont disposées du côté de la face inférieure de l'électrode r. A titre d'exemple, la distance entre l'électrode g1 et l'électrode r est sensiblement identique à la distance entre l'électrode g2 et l'électrode r. De façon similaire, la distance entre l'électrode g1b et l'électrode r peut être sensiblement identique à la distance entre l'électrode g2b et l'électrode r. De façon similaire à ce qui a été décrit en relation avec la figure 5, Les électrodes d et db sont disposées en vis à vis l'une de l'autre, de part et d'autre de l'électrode r. Plus particulièrement, dans cet exemple, l'électrode d est disposée du côté de la face supérieure de l'électrode r et l'électrode db est disposée du côté de la face inférieure de l'électrode r. Dans cet exemple, en position de repos (en l'absence de toute polarisation électrique), les électrodes g1 et g2 sont plus proches de l'électrode r que les électrodes g1b et g2b. De plus, dans cet exemple, en position de repos, la capacité Csd entre l'électrode r et l'électrode d est à sa valeur haute CsdH, et la capacité Csdb entre l'électrode r et l'électrode db est à sa valeur basse CsdbL. Dans l'exemple représenté, les électrodes g1, g2 et d d'une part, et g1b, g2b et db d'autre part, sont sensiblement coplanaires. Les modes de réalisation décrits ne se limitent toutefois pas à ce cas particulier. Dans cet exemple, l'électrode mobile r est reliée mécaniquement à un point PT de la structure fixe par l'intermédiaire d'un ressort 103.

Dans l'exemple de la figure 14, les électrodes g1 et g1b sont destinés à recevoir respectivement les signaux logiques d'entrée A et Ab, et les électrodes g2 et g2b sont destinées à recevoir respectivement les signaux logiques d'entrée B et Bb. De plus, les électrodes d et db sont destinées à fournir respectivement les signaux logiques de sortie S et Sb. L'électrode r est destinée à être reliée à un noeud d'application d'un potentiel de référence GND de la cellule. De façon similaire à ce qui a été décrit en relation avec la figure 9, la tension d'alimentation VPC de la cellule peut être appliquée sur les électrodes d et db par l'intermédiaire de condensateurs à capacité fixe.

La structure mobile est adaptée à se déplacer uniquement (ou de façon préférentielle) selon une direction MV orthogonale aux électrodes g1, g1b, g2, g2b, r, d et db, sous l'effet de la force électrostatique exercée par les électrodes g1 et g2 ou g1b et g2b sur l'électrode r. Dans l'exemple de la figure 14, seule la combinaison des signaux A=B=0 (et donc Ab=Bb=1) permet de déplacer la structure mobile vers le bas, et donc de placer les capacités Csd et Csdb respectivement à une valeur basse CsdL et à une valeur haute CsdbH, et donc les signaux de sortie S et Sb respectivement à l'état logique 1 et à l'état logique 0. Ceci correspond à la mise en oeuvre d'une fonction logique OU (S=A+B).

On notera que le dispositif de la figure 14 pourra être remplacé par un dispositif à huit électrodes en différentiant, sur la partie mobile, l'électrode r (placée entre les électrodes g1, g2 et g1b, g2b) d'une électrode s (placée entre les électrodes d et db), de façon similaire à ce qui a été décrit ci-dessus en relation avec les figures 6, 7 et 10. Dans ce cas, la tension d'alimentation VPC peut être appliquée directement sur l'électrode s.

La figure 15 illustre plus en détail un autre exemple de réalisation d'un dispositif à capacité variable à sept électrodes pour la réalisation d'une cellule combinatoire du type décrit en relation avec la figure 13.

Le dispositif de la figure 15 comprend les mêmes éléments que le dispositif de la figure 12A, agencés sensiblement de la même manière.

Le dispositif de la figure 15 comprend en outre deux régions conductrices 114' et 116', par exemple sensiblement de même forme et de mêmes dimensions que, respectivement, les régions 114 et 116, solidaires mécaniquement du cadre support 110 et disposées respectivement de part et d'autre de la poutre 112, à distance de la poutre 112. Dans cet exemple, la région 114' est disposée du même côté de la poutre 112 que la région 114, et la région 116' est disposée du même côté de la poutre 112 que la région 116. Dans l'exemple de la figure 15, en position de repos, la distance entre la région 114 et la poutre 112 est inférieure à la distance entre la région 116 et la poutre 112, et la distance entre la région 114' et la poutre 112 (par exemple sensiblement identique à la distance entre la région 114 et la poutre 112), est inférieure à la distance entre la région 116' et la poutre 112 (par exemple sensiblement identique à la distance entre la région 116 et la poutre 112).

Dans l'exemple de la figure 15, les électrodes g1 et g1b sont formées respectivement par les régions conductrices 114 et 116, et les électrodes g2 et g2b sont formées respectivement par les régions conductrices 114' et 116'.

Le fonctionnement du dispositif de la figure 15 est similaire à celui des figures 12A, 12B et 12C, à ceci près que, dans l'exemple de la figure 15, les signaux A et B doivent tous deux êtres à l'état logique 0 (les signaux Ab et Bb étant alors à l'état logique 1) pour faire basculer la poutre flexible 112 vers la droite, et donc le signal logique de sortie S à l'état logique 0 (et le signal logique Sb à l'état 1). Ceci correspond à la mise en oeuvre d'une fonction logique OU (S=A+B).

Le dispositif de la figure 15 peut par ailleurs être utilisé pour mettre en oeuvre une fonction NON OU, en inversant simplement la connexion des électrodes d et db, c'est-à-dire en connectant la borne de fourniture du signal de sortie S à l'électrode db et la borne de fourniture du signal de sortie Sb à l'électrode d. Ceci s'applique également au dispositif de la figure 14.

On notera que le dispositif de la figure 15 forme un dispositif micro-électromécanique à sept électrodes, dans lequel la tension d'alimentation VPC peut être appliquée sur les électrodes d et db par l'intermédiaire de condensateurs à capacité fixe de façon similaire à ce qui a été décrit ci-dessus en relation avec la figure 9. A titre de variante, la poutre flexible 112 peut supporter deux électrodes r et s disjointes, disposées respectivement entre les électrodes g1, g2 et g1b, g2b et entre les électrodes d et db. On obtient ainsi un dispositif à huit électrodes dans lequel la tension d'alimentation VPC peut être appliquée directement sur l'électrode s de façon similaire à ce qui a été décrit ci-dessus en relation avec la figure 7.

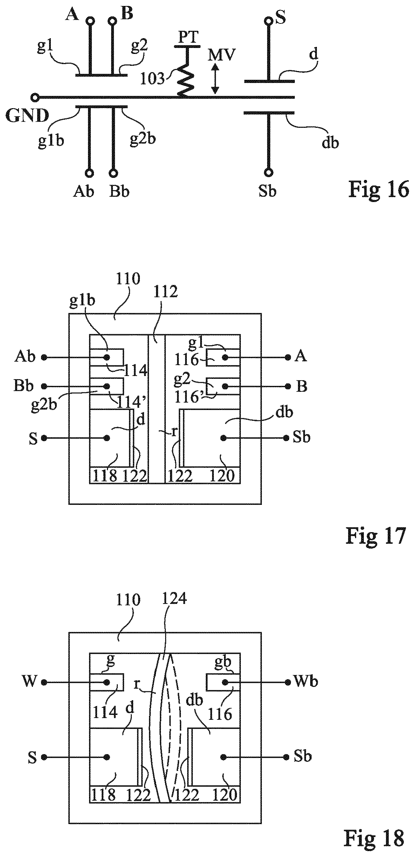

La figure 16 illustre schématiquement un autre exemple de réalisation d'un dispositif micro-électromécanique à capacité variable pour la réalisation d'une cellule combinatoire du type décrit en relation avec la figure 13. Dans cet exemple, le dispositif micro-électromécanique est adapté pour la mise en oeuvre d'une fonction ET.

Le dispositif de la figure 16 est similaire au dispositif de la figure 14, à ceci près que, dans l'exemple de la figure 16, en position de repos, les électrodes g1b et g2b sont plus proches de l'électrode r que les électrodes g1 et g2. De plus, dans cet exemple, en position de repos, la capacité Csd entre l'électrode r et l'électrode d est à sa valeur basse CsdL, et la capacité Csdb entre l'électrode r et l'électrode db est à sa valeur haute CsdbH.

Dans l'exemple de la figure 16, seule la combinaison des signaux A=B=1 (et donc Ab=Bb=0) permet de déplacer la structure mobile vers le haut, et donc de placer les capacités Csd et Csdb respectivement à une valeur haute CsdH et à une valeur basse CsdbL, et donc les signaux de sortie S et Sb respectivement à l'état logique 1 et à l'état logique 0. Ceci correspond à la mise en oeuvre d'une fonction logique ET (S=A.B).

On notera que le dispositif de la figure 16 peut être remplacé par un dispositif à huit électrodes en différentiant, sur la partie mobile, l'électrode r (placée entre les électrodes g1, g2 et g1b, g2b) d'une électrode s (placée entre les électrodes d et db), de façon similaire à ce qui a été décrit ci-dessus. Dans ce cas, la tension d'alimentation VPC peut être appliquée directement sur l'électrode s.

La figure 17 illustre plus en détail un autre exemple de réalisation d'un dispositif à capacité variable à sept électrodes pour la réalisation d'une cellule combinatoire du type décrit en relation avec la figure 13.

Le dispositif de la figure 17 comprend les mêmes éléments que le dispositif de la figure 15, agencés sensiblement de la même manière.

Le dispositif de la figure 17 diffère du dispositif de la figure 15 principalement en ce que, dans l'exemple de la figure 17, les connexions des électrodes g1 et g1b d'une part, et g2 et g2b d'autre part, sont inversées par rapport au dispositif de la figure 15. Autrement dit, dans l'exemple de la figure 17, les électrodes g1 et g1b sont formées respectivement par les régions conductrices 116 et 114, et les électrodes g2 et g2b sont formées respectivement par les régions conductrices 116' et 114'. Dans cet exemple, en position de repos, la capacité Csd entre l'électrode r et l'électrode d est à sa valeur basse CsdL, et la capacité Csdb entre l'électrode r et l'électrode db est à sa valeur haute CsdbH.

Le fonctionnement du dispositif de la figure 17 est similaire à celui de la figure 15, à ceci près que, dans l'exemple de la figure 17, les signaux A et B doivent tous deux êtres à l'état logique 1 (les signaux Ab et Bb étant alors à l'état logique 0) pour faire basculer la poutre flexible 112 vers la droite, et donc le signal logique de sortie S à l'état logique 1 (et le signal logique Sb à l'état 0). Ceci correspond à la mise en oeuvre d'une fonction logique ET (S=A.B).

Le dispositif de la figure 17 peut par ailleurs être utilisé pour mettre en oeuvre une fonction NON ET, en inversant simplement les connexions des électrodes d et db, c'est-à-dire en connectant l'électrode d à la borne de fourniture du signal S et l'électrode db à la borne de fourniture du signal Sb. Ceci s'applique également au dispositif de la figure 16.

On a décrit ci-dessus des exemples de réalisation de cellules logiques de type buffer, inverseur, ou encore des cellules adaptées à mettre en oeuvre des fonctions logiques combinatoires.

A titre de variante, on pourra adapter les exemples décrits ci-dessus pour réaliser des cellules de mémorisation en logique adiabatique capacitive à commande complémentaire, en utilisant des structures mécaniquement bistables du type décrit dans la demande de brevet EP3624123 susmentionnée, c'est-à-dire des structures comportant uniquement deux positions d'équilibre stable en l'absence de polarisation électrique. L'utilisation de telles structures permet notamment de conserver l'état des cellules même lorsqu'aucun signal d'entrée n'est appliqué ou lorsque la tension d'alimentation est interrompue.

La figure 18 illustre un exemple (non limitatif) de réalisation d'un dispositif micro-électromécanique à capacité variable de type bistable, permettant de réaliser une cellule de mémorisation en logique adiabatique capacitive à commande complémentaire.

Le dispositif de la figure 18 comprend les mêmes éléments que le dispositif de la figure 12A, agencés sensiblement de la même manière, et diffère du dispositif de la figure 12A principalement en ce que, dans le dispositif de la figure 18, la poutre flexible 112 du dispositif de la figure 12A a été remplacée par une poutre conductrice mécaniquement bistable 124. La poutre 124 est par exemple précontrainte à la fabrication. La poutre 124 comprend par exemple deux couches (non détaillées sur la figure) en des matériaux présentant des coefficients de dilatation thermique différents. Les deux positions d'équilibre stable de la poutre 124 sont représentées respectivement en trait plein et en trait interrompu sur la figure 18.

Dans l'exemple de la figure 18, les électrodes g et gb sont connectées respectivement à une borne d'application d'un signal logique d'entrée W et à une borne d'application d'un signal logique d'entrée Wb, complémentaire du signal W. Les électrodes d et db sont quant à elles connectées respectivement à une borne de fourniture d'un signal de sortie S et à une borne de fourniture d'un signal de sortie Sb, complémentaire du signal S. Les signaux W et Wb permettent de faire passer la poutre 124 de l'une à l'autre de ses deux positions d'équilibre stable. La bistabilité mécanique de la poutre 124 permet de conserver l'information en l'absence d'alimentation électrique de la cellule, ou lorsque les signaux d'entrée W et Wb sont laissés flottants.

On notera que le dispositif de la figure 18 forme un dispositif micro-électromécanique à cinq électrodes pouvant être intégré dans une cellule du type décrit en relation avec la figure 9. La tension d'alimentation VPC peut alors être appliquée sur les électrodes d et db par l'intermédiaire de condensateurs à capacité fixe. A titre de variante, la poutre conductrice bistable 124 peut supporter deux électrodes r et s disjointes, disposées respectivement entre les électrodes g et gb et entre les électrodes d et db. On obtient ainsi un dispositif à six électrodes pouvant être intégré dans une cellule du type décrit en relation avec la figure 7. La tension d'alimentation VPC peut alors être appliquée directement sur l'électrode s.

On a décrit ci-dessus des exemples de réalisation de dispositifs micro-électromécaniques à capacité variable à commande complémentaire dans lesquels la variation des capacités Csd et Csdb est obtenue en faisant varier l'espacement (gap) entre les électrodes desdites capacités, sans faire varier la surface en vis-à-vis desdites électrodes.

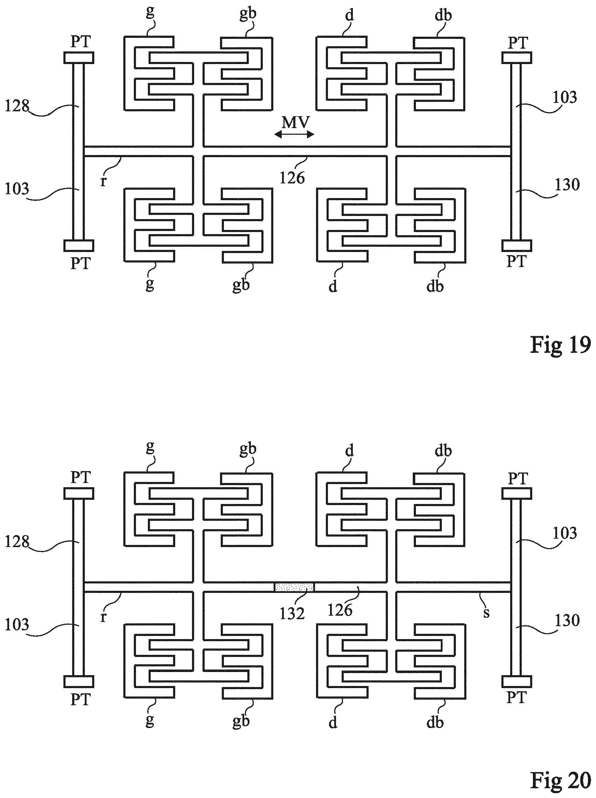

A titre de variante, les modes de réalisation décrits peuvent être mis en oeuvre au moyen de dispositifs micro-électromécaniques à capacité variable dans lesquels la variation des capacités Csd et Csdb est obtenue en faisant varier la surface de l'électrode mobile s ou r en vis-à-vis des électrodes fixes d et db. Des exemples (non limitatifs) de réalisation de tels dispositifs sont décrits ci-après en relation avec les figures 19 et 20.

La figure 19 illustre plus en détail un autre exemple de réalisation du dispositif à capacité variable à cinq électrodes de la figure 8.

Dans cet exemple, les électrodes d et r d'une part, et db et r d'autre part, sont en forme de peignes interdigités. Par ailleurs, dans cet exemple, les électrodes g et r d'une part, et gb et r d'autre part, sont-elles aussi en forme de peignes interdigités. Plus particulièrement, dans cet exemple, l'électrode r comprend plusieurs régions conductrices en forme de peignes, interdigitées respectivement avec des régions conductrices en peigne formant respectivement les électrodes g, gb, d et db. Les régions en peigne de l'électrode r sont reliées à une même poutre conductrice rigide 126. La poutre 126 est fixée à ses extrémités à des poutres flexibles 128 et 130 formant un ressort 103 de rappel en position de repos du dispositif. Dans cet exemple, les poutres flexibles 128 et 130 sont fixées à leurs extrémités à des points fixes PT de la structure.

Dans l'exemple de la figure 19, la structure mobile est adaptée à se déplacer selon une direction MV parallèle aux dents des peignes interdigités. Plus particulièrement, dans l'exemple représenté, lorsqu'une tension de niveau haut est appliquée sur l'électrode g et qu'une tension de niveau bas est appliquée sur l'électrode gb, l'électrode r est attirée par l'électrode g par effet électrostatique. Il en résulte que la surface des dents de peigne de l'électrode d en vis-à-vis de dents de peigne de l'électrode r augmente, tandis que la surface des dents de peigne de l'électrode db en vis-à-vis de dents de peigne de l'électrode r diminue. Ainsi, la capacité Csd (entre l'électrode r et l'électrode d) augmente et la capacité Csdb (entre l'électrode r et l'électrode db) diminue. A l'inverse, lorsqu'une tension de niveau bas est appliquée sur l'électrode g et qu'une tension de niveau haut est appliquée sur l'électrode gb, l'électrode r est attirée par l'électrode gb par effet électrostatique. Il en résulte que la surface des dents de peigne de l'électrode d en vis-à-vis de dents de peigne de l'électrode r diminue, tandis que la surface des dents de peigne de l'électrode db en vis-à-vis de dents de peigne de l'électrode r augmente. Ainsi, la capacité Csd (entre l'électrode r et l'électrode d) diminue et la capacité Csdb (entre l'électrode r et l'électrode db) augmente.

La figure 20 illustre plus en détail un autre exemple de réalisation du dispositif à capacité variable à six électrodes de la figure 6.

Le dispositif de la figure 20 comprend les mêmes éléments que le dispositif de la figure 19, agencés sensiblement de la même manière.

Le dispositif de la figure 20 diffère du dispositif de la figure 19 principalement en ce que, dans le dispositif de la figure 20, les régions conductrices en peigne de la structure mobile interdigitées avec les électrodes g et gb sont isolées électriquement des régions conductrices en peigne de la structure mobile interdigitées avec les électrodes d et db. Les régions conductrices en peigne de la structure mobile interdigitées avec les électrodes g et gb définissent l'électrode r, tandis que les régions conductrices en peigne de la structure mobile interdigitées avec les électrodes d et db définissent l'électrode s. Dans cet exemple, l'isolation électrique entre les électrodes s et r est assurée par une région diélectrique 132 intégrée à la poutre rigide 126.

Un avantage des modes de réalisation décrits ci-dessus réside dans le fait que la différentiation logique des états est rendue beaucoup plus robuste du fait de l'utilisation de signaux logiques complémentés appliqués à un même dispositif micro-électromécanique à au moins cinq électrodes.

Ceci permet notamment de relâcher les contraintes de précision géométrique pour la réalisation des dispositifs micro-électromécaniques.

Ceci permet en outre de réduire significativement les niveaux de tension utilisés dans la mesure où la différence de niveau de tension entre les états logiques 1 et 0 peut être réduite.

Par ailleurs, l'utilisation de signaux complémentés permet que l'activité logique soit décorrélée de la consommation du circuit logique. Ceci rend plus difficile l'estimation des niveaux logiques en cas d'attaque par analyse de la consommation électrique.

Plus généralement, les modes de réalisation décrits ci-dessus peuvent être adaptés à la mise en oeuvre de fonctions logiques plus complexes, par exemple des fonctions logiques à n entrées complémentées, avec n un entier supérieur ou égal à 3.

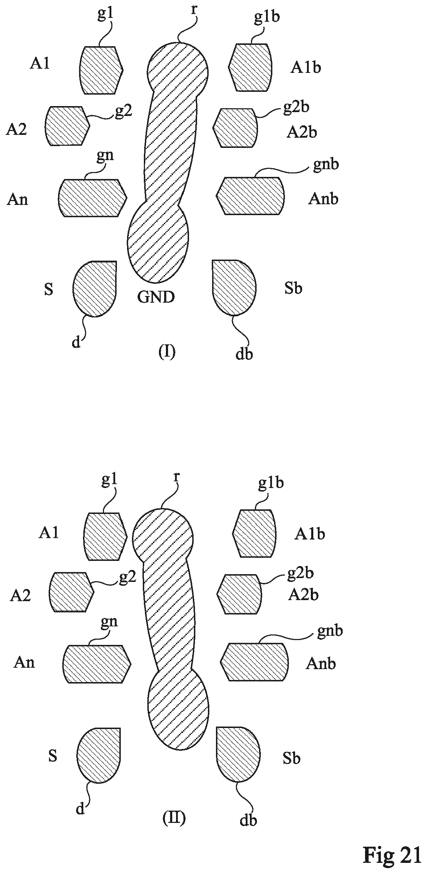

La figure 21 illustre un exemple d'un dispositif à capacité variable pour la réalisation d'une cellule logique adiabatique capacitive à n entrées complémentées. La figure 21 comprend deux vues (I) et (II) du dispositif, dans respectivement deux positions de fonctionnement différentes.

Le dispositif de la figure 21 comprend n paires d'électrodes fixes gi, gib, avec i entier allant de 1 à n. Les n électrodes gi sont destinées à recevoir respectivement n signaux logiques d'entrée Ai distincts. Les n électrodes gib sont destinées à recevoir respectivement n signaux logiques d'entrée Aib, complémentaires des signaux Ai.

Le dispositif de la figure 21 comprend en outre une électrode centrale mobile r pouvant prendre l'une ou l'autre de deux positions stables (représentées respectivement sur la vue (I) et sur la vue (II)) en fonction des états des signaux logiques d'entrée Ai, Aib appliqués sur les n paires d'électrodes fixes gi, gib. L'électrode r est par exemple destinée à être reliée à un potentiel fixe de référence GND, par exemple la masse.

Le dispositif de la figure 21 comprend de plus deux électrodes fixes d et db destinées à fournir respectivement un signal logique de sortie S et un signal logique de sortie Sb, complémentaire du signal S. Les électrodes r et d définissent une première capacité variable de sortie, et les électrodes r et db définissent une deuxième capacité variable de sortie.

La valeur de l'état logique de sortie est lue sur les électrodes d et db (signaux S et Sb), et est fonction des valeurs respectives des première et deuxième capacités variables de sortie. Les deux états logiques de sortie correspondent respectivement aux deux positions d'équilibre possibles de l'électrode mobile r.

Un choix adapté des formes et des positions des électrodes permet de réaliser une fonction logique à sortie complémentée, ayant pour entrées les n signaux logiques complémentés Ai, Aib. La fonction logique réalisée peut être une fonction ET, OU, NAND ou NOR. A titre de variante, des fonctions plus complexes peuvent être réalisées.

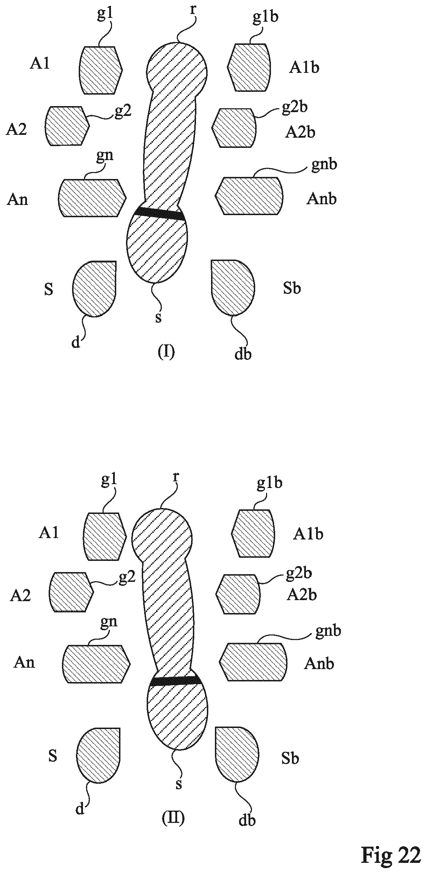

La figure 22 illustre une variante de réalisation du dispositif de la figure 21. La figure 22 comprend deux vues (I) et (II) du dispositif, dans respectivement deux positions de fonctionnement différentes.

La variante de la figure 22 diffère de l'exemple de la figure 21 principalement en ce que, dans cette variante, la partie mobile comprend deux électrodes r et s différentiées, c'est-à-dire isolées électriquement l'une de l'autre. L'électrode r est placée en vis-à-vis des électrodes gi, gib, tandis que l'électrode s est placée en vis-à-vis des électrodes d et db. Dans ce cas, la tension d'alimentation VPC peut être appliquée directement sur l'électrode s, de façon similaire à ce qui a été décrit ci-dessus, notamment en relation avec la figure 7.

Divers modes de réalisation et variantes ont été décrits. La personne du métier comprendra que d'autres variantes apparaîtront à la personne du métier sans sortir du cadre de l'invention. En particulier, bien que l'on ait décrit uniquement des exemples de réalisation de dispositifs à capacité variable à commande électrostatique, les modes de réalisation ne se limitent pas à ce cas particulier. En particulier, la personne du métier saura adapter les modes de réalisation décrits à des dispositifs à capacité variable à commande piézoélectrique ou à commande électrodynamique, par exemple tel que décrit en relation avec la figure 6 de la demande de brevet EP3416175 susmentionnée.

En outre, bien que cela n'ait pas été détaillé ci-dessus, les électrodes des dispositifs à capacité variable à commande électromécanique décrits ci-dessus peuvent être totalement ou partiellement recouvertes d'un isolant électrique.

De plus, bien que l'on ait décrit ci-dessus uniquement des exemples de dispositifs à capacité variable à commande électromécanique dans lesquels la partie mobile est mobile selon un unique degré de liberté en translation par rapport à la partie fixe, les modes de réalisation décrits ne se limitent pas à ce cas particulier. A titre de variante, la partie mobile peut être mobile en rotation par rapport à la partie fixe.

Par ailleurs, les modes de réalisation décrits ne se limitent pas aux exemples de fonctions logiques mentionnés dans la présente description. En particulier, la personne du métier saura, à partir des enseignements de la présente description, mettre en oeuvre des fonctions logiques plus complexe, par exemple à plus de deux entrées, au moyen d'un unique dispositif à capacité variable à commande électromécanique.

En outre, des fonctions logiques plus complexes peuvent être mises en oeuvre à partir d'un assemblage de cellules logiques élémentaires du type décrit dans la présente demande, par exemple des cellules de type ET, OU, NON ET et/ou NON OU.

Par ailleurs, on notera que les modes de réalisation décrits sont compatibles avec des architectures utilisant des tensions d'alimentation variables périodiques dites rétractables, aussi appelées architecture à cadencement de Bennett (Bennett clocking en anglais), par exemple du type décrit en relation avec la figure 9 de la demande de brevet EP3654534.

On notera en outre que les dispositifs à capacité variable à commande électromécanique décrits ci-dessus peuvent être utilisés en milieu liquide. Dans ce cas, les électrodes fixes sont séparées des électrodes mobiles par un liquide. Ceci permet notamment de réduire les niveaux de tension requis pour commuter entre les états logiques 1 et 0 des signaux, et de garantir une meilleure linéarité du déplacement des électrodes en fonction de la tension appliquée.

A titre de variante, les dispositifs à capacité variable à commande électromécanique décrits ci-dessus peuvent être utilisés en milieu gazeux ou sous vide.

## Revendications

1. Cellule logique capacitive à commande complémentaire, comportant un dispositif électromécanique à capacité variable comportant une partie fixe et une partie mobile, le dispositif électromécanique comportant des première (g ; g1), deuxième (gb ; glb), troisième (d) et quatrième (db) électrodes montées sur la partie fixe, et une cinquième électrode (r ; s) montée sur la partie mobile, dans lequel la première électrode (g ; g1) est reliée à une borne d'application d'un premier signal logique d'entrée (A ; A1) de la cellule, la deuxième électrode (gb ; g1b) est reliée à une borne d'application d'un deuxième signal logique d'entrée (Ab ; A1b) de la cellule, complémentaire du premier signal logique d'entrée (A ; A1), la troisième électrode (d) est reliée à une borne de fourniture d'un premier signal logique de sortie (S) de la cellule, et la quatrième électrode (db) est reliée à une borne de fourniture d'un deuxième signal logique de sortie (Sb) de la cellule, complémentaire du premier signal logique de sortie (S), dans laquelle les troisième (d) et cinquième (r ; s) électrodes définissent une première capacité (Csd) variable en fonction de la position de la partie mobile par rapport à la partie fixe, et les quatrième (db) et cinquième (r ; s) électrodes définissent une deuxième capacité (Csdb) variable en fonction de la position de la partie mobile par rapport à la partie fixe, et dans laquelle la position de la partie mobile par rapport à la partie fixe est fonction de l'état des premier (A) et deuxième (Ab) signaux logiques d'entrée complémentaires appliqués respectivement sur les première (g) et deuxième (gb) électrodes.

2. Cellule selon la revendication 1, dans laquelle la partie mobile est mobile par rapport à la partie fixe de façon à faire varier la distance entre les troisième (d) et cinquième (r ; s) électrodes et la distance entre les quatrième (db) et cinquième (r ; s) électrodes sans faire varier la surface de la troisième électrode (d) en vis-à-vis de la cinquième (r ; s) électrode ni la surface de la quatrième (db) électrode en vis-à-vis de la cinquième (r ; s) électrode.

3. Cellule selon la revendication 1 ou 2, dans laquelle la partie mobile est mobile par rapport à la partie fixe de façon à faire varier la surface de la cinquième (r ; s) électrode en vis-à-vis de la troisième électrode (d) et la surface de la cinquième électrode (r ; s) en vis-à-vis de la quatrième électrode (db) sans faire varier la distance entre les troisième (d) et cinquième (r ; s) électrodes ni la distance entre les quatrième (db) et cinquième (r ; s) électrodes.

4. Cellule selon l'une quelconque des revendications 1 à 3, comprenant en outre une borne d'application d'une tension d'alimentation variable périodique (VPC) et une borne d'application d'un potentiel de référence (GND).

5. Cellule selon la revendication 4, dans laquelle dans laquelle la cinquième électrode (r) est connectée à la borne d'application du potentiel de référence (GND), et les troisième (d) et quatrième (db) électrodes sont reliées à la borne d'application de la tension d'alimentation variable périodique (VPC) par l'intermédiaire respectivement de premier (CD) et deuxième (CDb) condensateurs à capacité fixe.

6. Cellule selon la revendication 5, dans laquelle le dispositif électromécanique à capacité variable comprend une sixième électrode (r) montée sur la partie mobile, la sixième électrode étant connectée à la borne d'application du potentiel de référence (GND) et la cinquième électrode (r) étant connectée à la borne d'application de la tension d'alimentation variable périodique.

7. Cellule selon l'une quelconque des revendications 1 à 6, dans laquelle la partie mobile comprend une poutre flexible (112) ancrée à au moins l'une de ses extrémités sur un support fixe (110).

8. Cellule selon l'une quelconque des revendications 1 à 7, dans laquelle la partie mobile comprend un élément bistable mécanique (124).

9. Cellule selon l'une quelconque des revendications 1 à 8, dans laquelle les troisième (d), quatrième (db) et cinquième (r ; s) électrodes sont en forme de peignes interdigités.

10. Cellule selon l'une quelconque des revendications 1 à 9, dans laquelle le dispositif électromécanique comportant en outre des septième (g2) et huitième (g2b) électrodes montées sur la partie fixe, dans lequel la septième électrode (g2) est reliée à une borne d'application d'un troisième signal logique d'entrée (B ; A2) de la cellule et la huitième électrode (g2b) est reliée à une borne d'application d'un quatrième signal logique d'entrée (Bb ; A2b) de la cellule, complémentaire du troisième signal logique d'entrée (B ; A2).

11. Cellule selon la revendications 9, dans laquelle le dispositif électromécanique comporte en outre des neuvième (gn) et dixième (gnb) électrodes montées sur la partie fixe, dans lequel la neuvième électrode (gn) est reliée à une borne d'application d'un troisième signal logique d'entrée (An) de la cellule et la huitième électrode (g2b) est reliée à une borne d'application d'un quatrième signal logique d'entrée (Anb) de la cellule, complémentaire du troisième signal logique d'entrée (An).

12. Circuit logique comportant des première et deuxièmes cellules logiques selon l'une quelconque des revendications 1 à 11, dans lequel la première cellule a sa borne de fourniture du premier signal logique de sortie (S) et sa borne de fourniture du deuxième signal logique de sortie (Sb) reliées respectivement à la borne d'application du premier signal logique d'entrée (A ; A1) et à la borne d'application du deuxième signal logique d'entrée (Ab ; A1b) de la deuxième cellule.

## Patentansprüche

1. Kapazitive Logikzelle mit komplementärer Steuerung, die eine elektromechanische Vorrichtung mit variabler Kapazität aufweist, die einen festen Teil und einen beweglichen Teil aufweist, wobei die elektromechanische Vorrichtung erste (g; g1), zweite (gb; g1b), dritte (d) und vierte (db) Elektroden, die an dem festen Teil angebracht sind, und eine fünfte Elektrode (r; s), die an dem beweglichen Teil angebracht ist, aufweist, wobei die erste Elektrode (g; g1) mit einem Anschluss zum Liefern eines ersten Eingangs-Logiksignals (A; A1) der Zelle verbunden ist, die zweite Elektrode (g; g1b) mit einem Anschluss zum Liefern eines zweiten Eingangs-Logiksignals (A; A1b) der Zelle verbunden ist, das komplementär zu dem ersten Eingangs-Logiksignals (A; A1) ist, die dritte Elektrode (d) mit einem Anschluss zum Liefern eines ersten Ausgangs-Logiksignals (S) der Zelle verbunden ist, und die vierte Elektrode (db) mit einem Anschluss zum Liefern eines zweiten Ausgangs-Logiksignals (Sb) der Zelle verbunden ist, das komplementär zu dem ersten Ausgangs-Logiksignal (S) ist,
wobei die dritte (d) und die fünfte (r; s) Elektrode eine erste Kapazität (Csd) definieren, die abhängig von der Position des beweglichen Teils in Bezug auf den festen Teil variabel ist, und die vierte (db) und die fünfte (r; s) Elektrode eine zweite Kapazität (Csdb) definieren, die abhängig von der Position des beweglichen Teils in Bezug auf den festen Teil variabel ist,
und wobei die Position des beweglichen Teils bezüglich des feste Teils vom Zustand ders ersten (A) und zweiten (Ab) komplementären Eingangs-Logiksignale abhängt, die an die erste (g) bzw. zweite (gb) Elektrode angelegt werden.

2. Zelle nach Anspruch 1, wobei der bewegliche Teil in Bezug auf den feststehenden Teil beweglich ist, um den Abstand zwischen der dritten (d) und der fünften (r; s) Elektrode und den Abstand zwischen der vierten (db) und der fünften (r; s) Elektrode zu verändern, ohne die der dritten Elektrode (d) gegenüberliegende Fläche der fünften (r; s) Elektrode oder die der vierten (db) Elektrode gegenüberliegende Fläche der fünften (r; s) Elektrode zu verändern.

3. Zelle nach Anspruch 1 oder 2, wobei der bewegliche Teil in Bezug auf den festen Teil beweglich ist, um die der fünften Elektrode (r; s) gegenüberliegende Fläche der dritten Elektrode (d) und die der fünften Elektrode (r; s) gegenüberliegende Fläche der vierten Elektrode (db) zu verändern, ohne den Abstand zwischen der dritten (d) und der fünften (r; s) Elektrode oder den Abstand zwischen der vierten (db) und der fünften (r; s) Elektrode zu verändern.

4. Zelle nach einem der Ansprüche 1 bis 3, ferner mit einem Anschluss zum Liefern einer periodisch veränderlichen Versorgungsspannung (VPC) und einem Anschluss zum Liefern eines Bezugspotentials (GND).

5. Zelle nach Anspruch 4, wobei die fünfte Elektrode (r) mit dem Anschluss zum Liefern des Referenzpotentials (GND) verbunden ist und die dritte (d) und vierte (db) Elektrode mit dem Anschluss zum Liefern der variablen Versorgungsspannung (VPC) über einen ersten (CD) bzw. zweiten (CDb) Kondensator mit fester Kapazität verbunden sind.

6. Zelle nach Anspruch 5, wobei die elektromechanische Vorrichtung mit variabler Kapazität eine sechste Elektrode (r) aufweist, die an dem beweglichen Teil angebracht ist, wobei die sechste Elektrode mit dem Anschluss zum Liefern des Referenzpotentials (GND) verbunden ist und die fünfte Elektrode (r) mit dem Anschluss zum Liefern der periodisch variablen Versorgungsspannung verbunden ist.

7. Zelle nach einem der Ansprüche 1 bis 6, **dadurch gekennzeichnet, dass** der bewegliche Teil einen flexiblen Balken (112) aufweist, der zumindest an einem seiner Enden an einem festen Träger (110) verankert ist.

8. Zelle nach einem der Ansprüche 1 bis 7, wobei der bewegliche Teil ein mechanisches bistabiles Element (124) aufweist.

9. Zelle nach einem der Ansprüche 1 bis 8, wobei die dritte (d), vierte (db) und fünfte (r; s) Elektrode die Form von ineinandergreifenden Kämmen haben.

10. Zelle nach einem der Ansprüche 1 bis 9, wobei die elektromechanische Vorrichtung ferner siebte (g2) und achte (g2b) Elektroden aufweist, die an dem festen Teil angebracht sind, wobei die siebte Elektrode (g2) mit einem Anschluss zum Liefern eines dritten Eingangs-Logiksignals (B; A2) der Zelle verbunden ist und die achte Elektrode (g2b) mit einem Anschluss zum Liefern eines vierten Eingangs-Logiksignals (Bb; A2b) der Zelle verbunden ist, das komplementär zu dem dritten Eingangs-Logiksignals (B; A2) ist.

11. Zelle nach Anspruch 9, wobei die elektromechanische Vorrichtung ferner neunte (gn) und zehnte (gnb) Elektroden aufweist, die an dem festen Teil angebracht sind, wobei die neunte Elektrode (gn) mit einem Anschluss zum Liefern eines dritten Eingangs-Logiksignals (An) der Zelle verbunden ist und die achte Elektrode (g2b) mit einem Anschluss zum Liefern eines vierten Eingangs-Logiksignals (Anb) der Zelle verbunden ist, das zu dem dritten Eingangs-Logiksignals (An) komplementär ist.

12. Logiskschaltung mit einer ersten und einer zweiten Logikzelle nach einem der Ansprüche 1 bis 11, wobei die erste Zelle mit ihrem Anschluss zum Liefern des ersten Ausgangs-Logiksignals (S) und mit ihrem Anschluss zum Liefern des zweiten Ausgangs-Logiksignals (Sb) mit dem Anschluss zum Liefern des ersten Eingangs-Logiksignals (A; A1) bzw. mit dem Anschluss zum Liefern des zweiten Eingangs-Logiksignals (Ab; A1b) der zweiten Zelle verbunden ist.

## Claims

1. A capacitive logic cell with complementary control comprising a variable capacitance electromechanical device comprising a fixed part and a movable part, the electromechanical device comprising first (g; g1), second (gb; glb), third (d), and fourth (db) electrodes mounted on the fixed part, and a fifth electrode (r; s) mounted on the movable part, wherein the first electrode (g; g1) is connected to a terminal for supplying a first input logic signal (A; A1) of the cell, the second electrode (g; g1b) is connected to a terminal for supplying a second input logic signal (A; A1b) of the cell, complementary to the first input logic signal (A ; A1), the third electrode (d) is connected to a terminal for supplying a first output logic signal (S) of the cell, and the fourth electrode (db) is connected to a terminal for supplying a second output logic signal (Sb) of the cell, complementary to the first output logic signal (S),
wherein the third (d) and fifth (r; s) electrodes define a first capacitance (Csd) variable, depending on the position of the movable part in relation to the fixed part, and the fourth (db) and fifth (r; s) electrodes define a second capacitance (Csdb) variable, depending on the position of the movable part in relation to the fixed part,
and wherein the position of the movable part in relation to the fixed part depends on the state of the first (A) and second (Ab) complementary input logic signals applied to the first (g) and second (gb) electrodes, respectively.

2. The cell according to claim 1, wherein the movable part is movable in relation to the fixed part so as to vary the distance between the third (d) and fifth (r; s) electrodes and the distance between the fourth (db) and fifth (r; s) electrodes without varying the surface of the third electrode (d) opposite the fifth (r; s) electrode or the surface of the fourth (db) electrode opposite the fifth (r; s) electrode.

3. The cell according to claim 1 or 2, wherein the movable part is movable in relation to the fixed part so as to vary the area of the fifth electrode (r; s) opposite the third electrode (d) and the surface of the fifth electrode (r; s) opposite the fourth electrode (db) without varying the distance between the third (d) and fifth (r; s) electrodes or the distance between the fourth (db) and fifth (r; s) electrodes.

4. The cell according to any one of claims 1 to 3, further comprising a terminal for supplying a periodic variable supply voltage (VPC) and a terminal for supplying a reference potential (GND).

5. The cell according to claim 4, wherein the fifth electrode (r) is connected to terminal for supplying the reference potential (GND), and the third (d) and fourth (db) electrodes are connected to the terminal for supplying the variable supply voltage (VPC) via first (CD) and second (CDb) fixed capacitance capacitors, respectively.

6. The cell according to claim 5, wherein the variable capacitance electromechanical device comprises a sixth electrode (r) mounted on the movable part, the sixth electrode being connected to the terminal for supplying the reference potential (GND) and the fifth electrode (r) being connected to the terminal for supplying the periodic variable supply voltage.

7. The cell according to any one of claims 1 to 6, wherein the movable part comprises a flexible beam (112) anchored to a fixed support (110) at one of its ends at least.

8. The cell according to any one of claims 1 to 7, wherein the movable part comprises a mechanical bistable element (124).

9. The cell according to any one of claims 1 to 8, wherein the third (d), fourth (db) and fifth (r; s) electrodes are in the shape of interdigitated combs.

10. The cell according to any one of claims 1 to 9, wherein the electromechanical device further comprises seventh (g2) and eighth (g2b) electrodes mounted on the fixed part, wherein the seventh electrode (g2) is connected to terminal for supplying a third input logic signal (B; A2) of the cell and the eighth electrode (g2b) is connected to a terminal for supplying a fourth input logic signal (Bb; A2b) of the cell, complementary to the third input logic signal (B; A2).

11. The cell according to claim 9, wherein the electromechanical device further comprises ninth (gn) and tenth (gnb) electrodes mounted on the fixed part, wherein the ninth electrode (gn) is connected to a terminal for supplying a third input logic signal (An) of the cell and the eighth electrode (g2b) is connected to a terminal for supplying a fourth input logic signal (Anb) of the cell, complementary to the third input logic signal (An).

12. A logic circuit comprising first and second logic cells according to any one of claims 1 to 11, wherein the first cell has its terminal for supplying the first output logic signal (S) and its terminal for supplying the second output logic signal (Sb) respectively connected to the terminal for supplying the first input logic signal (A; A1) and to the terminal for supplying the second input logic signal (Ab; A1b) of the second cell.
